# FASCICULE DE BREVET EUROPEEN

(11) **EP 2 239 142 B1**
(45) Date de publication et mention de la délivrance du brevet: **24.09.2014**
(21) Numéro de dépôt: 10158466.2
(22) Date de dépôt: 30.03.2010
(51) Int. Cl.: H05K 3/12, B41F 33/00, B41F 15/12, B41F 15/08, B41M 1/12, B41M 3/00, H01L 31/0224, H05K 1/02, H05K 3/00, H05K 3/24

(54) **Procédé d'impression par sérigraphie d'un conducteur en deux couches superposées**
Verfahren zum Siebdrucken auf einem Leiter aus zwei übereinander angeordneten Schichten
Method for silk screen printing onto a conductor made of two superposed layers

(30) Priorité: 06.04.2009 FR 0901711
(43) Date de publication de la demande: 13.10.2010
(73) Titulaire: Commissariat à l'Énergie Atomique et aux Énergies Alternatives, 75015 Paris (FR)
(72) Inventeur: Bettinelli, Armand, 38500 Coublevie (FR)
(74) Mandataire: Novaimo

(56) Documents cités:
- EP-A- 1 935 647
- FR-A- 2 807 705
- US-A- 5 806 424
- US-A- 5 899 143
- US-A1- 2002 026 879
- US-B1- 7 473 502
- BESU-VETRELLA U ET AL: "Large area, screen printed silicon solar cells with selective emitter made by laser overdoping and RTA spin-on glasses" CONFERENCE RECORD OF THE 26TH IEEE PHOTOVOLTAIC SPECIALISTS CONFERENCE 19970929; 19970929 - 19971003 NEW YORK, NY : IEEE, US, 29 septembre 1997 (1997-09-29) , pages 135-138, XP010267745 ISBN: 978-0-7803-3767-1
- MOUHOUB A ET AL: REVUE DES ENERGIES RENOUVELABLES, 2003, pages 83-86, XP002559146
- PIROZZI L ET AL: LASER APPLICATIONS IN MICROELECTRONIC AND OPTOELECTRONIC MANUFACTURING II 10-12 FEB. 1997 SAN JOSE, CA, USA, vol. 2991, 1997, pages 119-128, XP002576513 Proceedings of the SPIE - The International Society for Optical Engineering SPIE-Int. Soc. Opt. Eng USA ISSN: 0277-786X

## Description

L'invention concerne un procédé d'alignement d'une unité d'impression par sérigraphie, particulièrement adapté à l'impression en double couches de conducteurs de collecte sur une cellule photovoltaïque. Elle concerne aussi une unité d'impression mettant en oeuvre un tel procédé, une unité de production de cellules photovoltaïques et une cellule et un module photovoltaïques produits par une telle unité.

Une cellule photovoltaïque est fabriquée à l'aide d'une plaque en matériau semi-conducteur, généralement en silicium, connu sous sa dénomination anglaise de « wafer ». Cette fabrication nécessite en particulier la formation de conducteurs électriques sur la surface de cette plaque. Pour cela, une méthode de l'état de la technique consiste à déposer une encre conductrice par sérigraphie sur la plaque. En variante, il existe d'autres techniques pour réaliser ces conducteurs électriques.

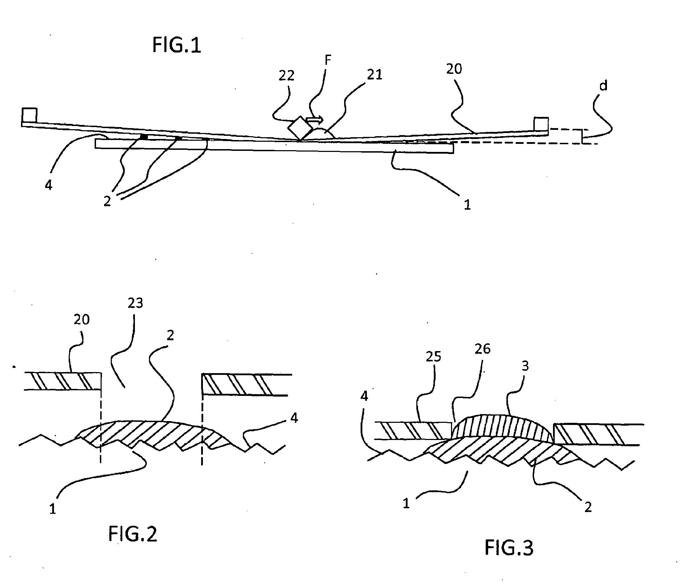

Les figures 1 et 2 illustrent cette méthode. La sérigraphie repose sur l'utilisation d'un écran ou masque 20 positionné au-dessus d'une plaque ou wafer 1 à sérigraphier, à une distance de l'ordre du millimètre. Une racle 22 se déplace dans le sens de la flèche F en déformant l'écran 20 jusqu'à la surface 4 de la plaque 1 et en exerçant une force de pression qui dépose une partie de l'encre 21 sur la surface 4 de la plaque 1 aux endroits prédéfinis aux travers d'ouvertures 23 de l'écran, pour former des conducteurs étroits 2 sur sa surface. Ces conducteurs 2 présentent en général une largeur supérieure à celle de l'ouverture 23, de l'ordre de 20 micromètres, comme cela apparaît particulièrement sur la figure 2.

La propriété électrique des conducteurs 2 obtenus joue un rôle important dans les performances finales de la cellule photovoltaïque, est notamment déterminante pour son rendement de conversion. Une caractéristique du procédé par sérigraphie décrit ci-dessus est qu'avec le temps, l'écran s'use du fait de la répétition de ses déformations. Un tel écran subit en effet des fortes contraintes dans le processus de fabrication de cellules photovoltaïques qui exige des vitesses élevées, de l'ordre de 1200 impressions à l'heure. Ces contraintes induisent en particulier la déformation progressive de l'écran et donc la déformation du motif imprimé.

A titre d'exemple, le document XP010267745 décrit une telle solution consistant à réaliser des contacts électriques par sérigraphie sur une cellule photovoltaïque. Ces contacts sont réalisés en une seule couche d'impression en utilisant des mires pour améliorer la précision de cette impression.

Pour pallier à ces inconvénients, il est connu d'utiliser un dispositif d'inspection reposant sur une ou plusieurs caméras, qui observe les plaques de semi-conducteurs ou wafers et détecte leur intégrité, puis observe la position de la plaque pour améliorer l'alignement entre la plaque et l'écran de sérigraphie. Un tel dispositif d'inspection permet d'atteindre une précision suffisante, compatible avec la précision recherchée de l'ordre de 50 à 100 micromètres.

Pour améliorer les performances de la cellule photovoltaïque, il est connu un second procédé consistant à réaliser les conducteurs par deux impressions superposées, comme cela est représenté sur la figure 3. La seconde impression permet d'imprimer une seconde couche conductrice 3 par sérigraphie à l'aide d'un second écran distinct 25 sur la première couche conductrice 2 obtenue par la première impression. La largeur de la seconde couche 3 est proche de l'ouverture 26 de l'écran 25, placé en appui sur la première couche 2. Cette caractéristique facilite la superposition des deux couches conductrices 2, 3. L'objectif est d'obtenir un conducteur final plus épais, qui permet de réduire d'un facteur proche de deux la résistance des conducteurs de collecte, ce qui augmente considérablement le rendement de conversion de la cellule photovoltaïque. Mais cette méthode doit être mise en oeuvre par deux impressions successives réalisées avec deux têtes de sérigraphie différentes, sur la base de deux écrans différents 20, 25 pour permettre le séchage de la première couche conductrice 2 avant la superposition de la seconde couche 3.

L'amélioration des cellules photovoltaïques par le second procédé à double impression n'est obtenue qu'à la condition d'obtenir une superposition suffisante des deux couches conductrices 2, 3. En effet, si la seconde couche est mal superposée à la première, elle entraîne un élargissement des conducteurs, ce qui augmente la surface non utilisable par la cellule (surface avec un matériau non sensible aux photons) et par conséquent diminue la performance de la cellule photovoltaïque. Or le phénomène de décalage de l'alignement des écrans 20, 25 avec le temps est plus critique dans cette solution de double impression, du fait du cumul de deux écrans qui se déforment tous deux de manière différente avec le temps. Ainsi, cette solution exige aujourd'hui le changement fréquent des écrans toutes les 1000 impressions, alors que l'écran peut être conservé pour 5 à 10000 impressions avec la solution standard de mono-impression. Cette seconde méthode de double impression présente donc l'inconvénient de nécessiter une consommation accrue d'écrans, ce qui augmente sensiblement son coût. De plus, la perte de temps induite par les changements d'écrans réduit la productivité du procédé de fabrication de cellules photovoltaïques.

Finalement, l'amélioration des cellules photovoltaïques par le second procédé à double impression reste théorique et peu applicable du fait des inconvénients mentionnés ci-dessus.

En remarque, le document US7473502 décrit une méthode pour corriger l'erreur d'un dispositif d'imagerie. Cette méthode ne porte pas sur un procédé d'impression par sérigraphie et se trouve dans un domaine éloigné de la présente invention.

Ainsi, un objet général de l'invention est de proposer une solution de réalisation d'un conducteur électrique par sérigraphie sur une plaque qui réduit les inconvénients des solutions de l'état de la technique.

Plus précisément, l'invention cherche à atteindre tout ou partie des objets suivants :
Un premier objet de l'invention est de proposer une solution de réalisation d'un conducteur électrique par sérigraphie sur une cellule photovoltaïque permettant l'optimisation de la performance de la cellule photovoltaïque résultante.
Un second objet de l'invention est de proposer une solution de réalisation d'un conducteur électrique par sérigraphie sur une cellule photovoltaïque par un procédé à forte productivité, performant et économique.

A cet effet, l'invention repose sur un procédé d'impression par sérigraphie d'une plaque, caractérisé en ce qu'il comprend les étapes suivantes :
- réalisation d'au moins deux premières mires sur la surface de la plaque ;
- Impression d'au moins quatre secondes mires, distinctes des au moins deux premières mires, lors d'une impression par sérigraphie sur la surface de la plaque ;
- Mesure de l'écart réel obtenu sur la surface de la plaque entre les premières mires et les secondes mires ;
- Comparaison de cet écart réel avec l'écart théorique pour en déduire le décalage de l'écran sérigraphique de l'impression.

Les mires peuvent être réparties de manière symétrique autour d'un même centre de symétrie dans leur position théorique obtenue lors d'une impression sans décalage des écrans sérigraphiques.

Les mires peuvent être réparties dans les quatre angles si la plaque est un parallélogramme.

En variante, les premières mires et les secondes mires peuvent toutes être décalées de la même manière d'une distance (P).

Les premières mires et les secondes mires peuvent comprendre une partie du circuit sérigraphié.

Le procédé d'impression peut comprendre une étape d'entrée de la plaque sur une table d'impression, une étape de positionnement de la plaque dans une unité d'impression où elle subit la seconde impression, et une étape de positionnement de la plaque dans une unité d'inspection pour mesurer et en déduire le décalage de l'écran sérigraphique de la seconde impression.

La première étape d'entrée sur la table d'impression peut positionner la plaque dans l'unité d'inspection pour mesurer la position des mires de la première impression, l'étape de positionnement de la plaque dans une unité d'inspection peut consister en un positionnement par un mouvement arrière de la plaque sous la même unité d'inspection que celle atteinte lors de l'entrée de la plaque sur la table d'impression, et le procédé peut comprendre une étape de repositionnement de la plaque sous l'unité d'impression sans réaliser son impression avant sa sortie de la table d'impression.

L'inspection de la seconde impression dans l'unité d'inspection peut n'être réalisée que périodiquement, pas pour toutes les plaques.

L'invention porte aussi sur un procédé de fabrication d'une cellule photovoltaïque, **caractérisé en ce qu**'il comprend un procédé d'impression de tout ou partie des conducteurs de collecte de la cellule photovoltaïque tel que décrit précédemment.

L'invention porte aussi sur dispositif d'impression sérigraphique comprenant au moins une unité d'impression sérigraphique et au moins une unité d'inspection, **caractérisé en ce que** l'unité d'impression sérigraphique met en oeuvre l'impression d'au moins quatre mires et en ce que le dispositif met en oeuvre le procédé d'impression par sérigraphie tel que décrit précédemment.

L'unité d'inspection peut comprendre au moins une caméra à haute résolution et un calculateur.

Enfin, l'invention porte aussi sur une cellule photovoltaïque, **caractérisée en ce qu**'elle comprend au moins un conducteur comprenant au moins deux couches superposées, et au moins deux premières mires et au moins quatre secondes mires sérigraphiques distinctes.

Elle peut comprendre au moins quatre premières mires sérigraphiques.

Ces objets, caractéristiques et avantages de la présente invention seront exposés en détail dans la description suivante de modes d'exécution particuliers faits à titre non-limitatif en relation avec les figures jointes parmi lesquelles :
La figure 1 illustre schématiquement un procédé de sérigraphie selon l'état de la technique.
La figure 2 représente schématiquement le résultat obtenu par un premier procédé de sérigraphie selon l'état de la technique.
La figure 3 représente schématiquement le résultat obtenu par un second procédé de sérigraphie selon l'état de la technique.
La figure 4 illustre schématiquement une plaque après une première impression selon un mode d'exécution de l'invention.
La figure 5 illustre schématiquement la même plaque après la seconde impression selon le mode d'exécution de l'invention.
Les figures 6a à 6e représentent la méthode de détermination du décalage de la seconde impression selon un mode d'exécution de l'invention.
Les figures 7a à 7e représentent la méthode de détermination du décalage de la seconde impression selon un autre mode d'exécution de l'invention.
La figure 8 représente une unité d'impression selon un mode d'exécution de l'invention.
La figure 9 représente un mode d'utilisation de l'unité d'impression selon le mode d'exécution de l'invention.
La figure 10 illustre schématiquement une plaque après une première impression selon un autre mode d'exécution de l'invention.
La figure 11 illustre schématiquement la plaque après la seconde impression selon cet autre mode d'exécution de l'invention.

L'invention repose sur l'exploitation d'un dispositif d'inspection permettant de corriger les défauts d'alignement dans un dispositif mettant en oeuvre la double impression pour former des conducteurs en deux couches superposées dont au moins la seconde est réalisée par sérigraphie.

Pour cela, l'invention propose de réaliser une première couche conductrice sur une plaque par tout procédé, par exemple par l'ajout d'encre par une méthode de jet d'encre, de sérigraphie ou par une des deux méthodes connues par leur dénomination anglaise de « dispensing » ou « lift off ». En variante, la première couche peut être réalisée par l'utilisation de pâtes gravantes, d'ablation laser, un dépôt pleine plaque suivie d'une photolithographie et d'une gravure.

L'invention permet finalement de cumuler une productivité équivalente à celle d'une solution standard à une seule impression et l'obtention de cellules photovoltaïques à haut rendement de conversion du fait de ses conducteurs de collecte épais. Elle est particulièrement adaptée à la fabrication des cellules photovoltaïques par double impression sérigraphique.

Toutefois, elle reste adaptée à toute fabrication de composants électroniques nécessitant la formation de deux réseaux qui requièrent un alignement relatif précis et dont au moins le second est réalisé par sérigraphie.

Ainsi, il peut s'agir de deux niveaux superposés, par exemple deux niveaux de conducteurs métalliques mais aussi deux niveaux de matériaux quelconques. Cela peut en particulier être utilisé favorablement pour la réalisation de cellules photovoltaïques à émetteurs sélectifs, par exemple en alignant la sérigraphie d'un deuxième niveau métallique sur un premier niveau constitué d'un motif émetteur en silicium fortement dopé.

II peut s'agir plus généralement de deux motifs pas forcément superposés mais devant avoir un positionnement relatif précis et dont au moins le second est réalisé par sérigraphie, par exemple deux motifs côte à côte tels que deux motifs interdigités et dont les précisions d'alignement des niveaux apportés par l'invention permettront de réduire la distance entre les deux motifs. Cela peut en particulier être utilisé favorablement pour la réalisation des deux niveaux de conducteurs interdigités de cellules photovoltaïques à contacts face arrière (amélioration des performances par réduction des espaces entre les zones de polarités inverses).

Dans la description suivante, les mêmes références seront utilisées pour désigner les éléments similaires.

Le procédé d'impression et d'inspection selon un mode d'exécution de l'invention basé sur la superposition de deux couches d'encre conductrice par sérigraphie va maintenant être détaillé.

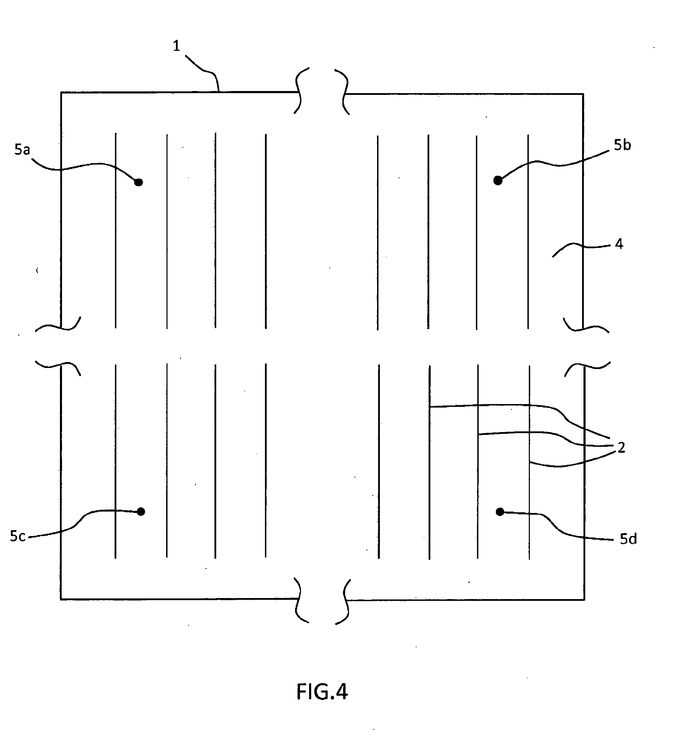

La figure 4 représente une première étape du procédé, réalisée lors de la première impression par sérigraphie, qui permet d'imprimer la première couche 2 des conducteurs sur la surface 4 de la plaque 1.

Selon un élément essentiel de l'invention, cette première impression imprime des premiers motifs d'alignement ou premières mires 5a, 5b, 5c, 5d, dont la seule fonction est de permettre par l'observation de leur position dans un dispositif d'inspection, basé sur des caméras, de déterminer la position réelle de la première impression sur la plaque.

Ainsi, une seconde étape du dispositif consiste à inspecter le résultat obtenu après la première impression. Cette inspection permet de reconnaître les premiers motifs d'alignement 5a à 5d, et de les localiser précisément.

Dans certains cas, il peut être avantageux de calculer l'écart de leur position réelle par rapport à leur position théorique, définie par la position obtenue avec un écran neuf et parfaitement aligné. Cet écart peut être pris en compte par une première correction à appliquer lors de la prochaine première impression.

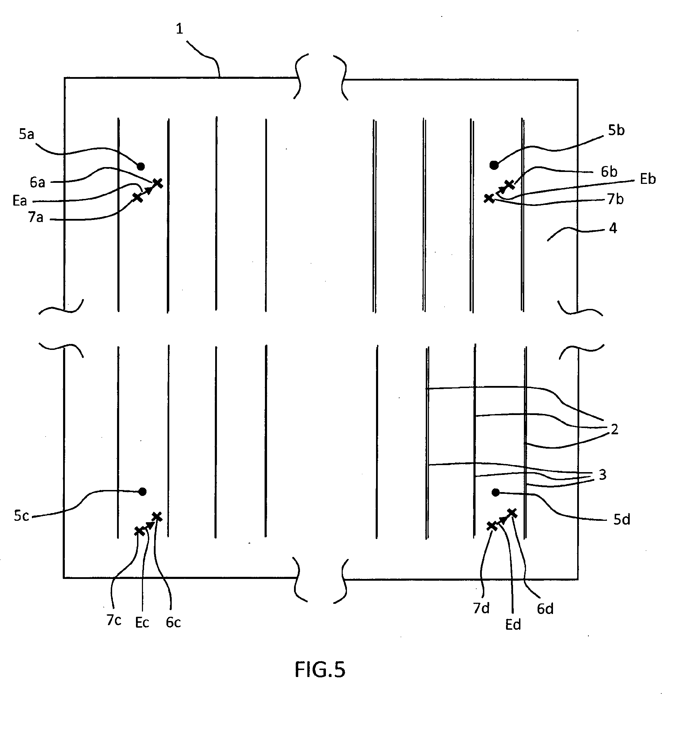

Ensuite, une troisième étape du procédé consiste en une seconde impression, représentée sur la figure 5, durant laquelle une seconde couche conductrice 3 vient en superposition sur la première couche conductrice 2. Selon un autre élément essentiel de l'invention, cette seconde impression réalise l'impression entre autres de seconds motifs d'alignement ou secondes mires 6a, 6b, 6c, 6d.

Ensuite, une quatrième étape, semblable à la seconde, permet de détecter l'écart Ea à Ed de positionnement des secondes mires 6a à 6d par rapport à leur position théorique 7a à 7d définie par le résultat obtenu à l'aide d'un écran neuf non déformé et parfaitement aligné. La localisation théorique 7a à 7d des secondes mires est obtenue en tenant compte des données de localisation des premiers motifs 5a à 5d.

La position théorique des secondes mires est calculée à partir de la localisation des premières mires, en tenant compte de leur décalage relatif théorique, c'est-à-dire avec des écrans sérigraphiques parfaitement alignés et sans déformation. L'écart Ea à Ed obtenu correspond donc à l'écart relatif des secondes mires par rapport aux premières et permet de déterminer les écarts de positionnement résiduels entre les deux impressions.

La réalisation des mires précédentes représente une illustration à titre d'exemple et il existe une multitude de possibilités. Par exemple, les premiers et/ou seconds motifs d'alignement pourraient être une partie des conducteurs 2, 3. Toutefois, il est avantageux de dissocier la fonction d'inspection de la structure propre de la cellule photovoltaïque. Il est ainsi possible de donner aux premiers et/ou seconds motifs d'alignement 5a à 5d, 6a à 6d des formes et dimensions idéales pour leur inspection optique. Ces motifs peuvent ainsi présenter une petite taille, afin de minimiser les surfaces non réceptrices des photons, et peuvent par exemple présenter une forme partiellement sphérique, de diamètre de l'ordre de 100 micromètres, ou une forme de bâtonnets, orientés préférentiellement dans le même sens que les conducteurs de collecte et de dimension par exemple égale à 300 X 70 micromètres, ou une forme de croix. D'autre part, ces mires peuvent se trouver à tout endroit sur la surface 4 de la plaque 1, de préférence en périphérie de la plaque ou dans les angles pour une plaque en forme de parallélogramme. De plus, leur nombre doit être supérieur ou égal à quatre afin d'atteindre une information suffisante sur la déformation des écrans et le décalage des impressions. De plus, les secondes mires peuvent avantageusement présenter un aspect différent des premières de sorte d'être facilement différenciées. Dans tous les cas, les secondes mires seront distinctes des premières, afin de permettre leur reconnaissance et exploitation optique de manière efficace.

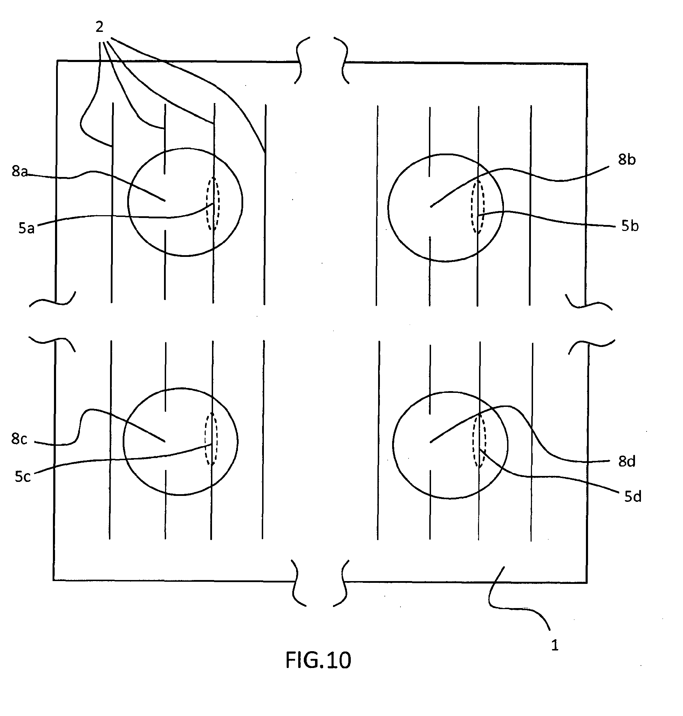

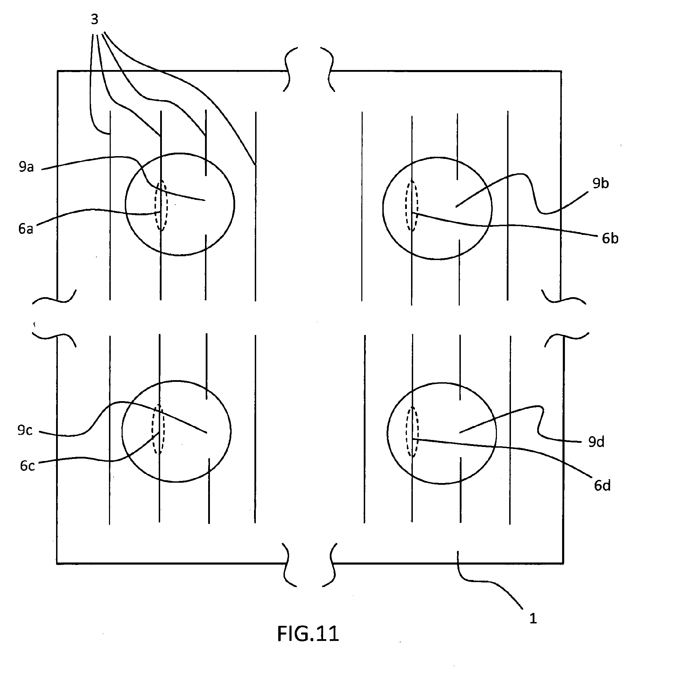

Selon une variante d'exécution, les motifs d'alignement peuvent être intégrés au sein des conducteurs 2. Pour cela, certaines parties des conducteurs 2 peuvent n'être imprimées que lors de la première impression et d'autres uniquement lors de la seconde impression. Par exemple, les figures 10 et 11 représentent une mise en oeuvre de cette variante dans laquelle la première impression représentée sur la figure 10 montre des zones 8a à 8d pour lesquelles les conducteurs 2 ne sont pas imprimés. De même, la figure 11 représente la seconde impression réalisée dans laquelle des zones 9a à 9d des conducteurs 3 ne sont pas imprimées, ces zones étant distinctes des zones 8a à 8d. Toutes ces zones peuvent être avantageusement disposées dans les angles de la plaque 1. Ainsi, lorsque les deux impressions sont effectuées, on obtient bien la continuité de l'ensemble des conducteurs 2, 3. Le dispositif d'inspection ou de visualisation de l'alignement sera focalisé sur ces zones particulières pour analyser visuellement les défauts d'alignement, notamment les zones 5a-5d et 6a-6d.

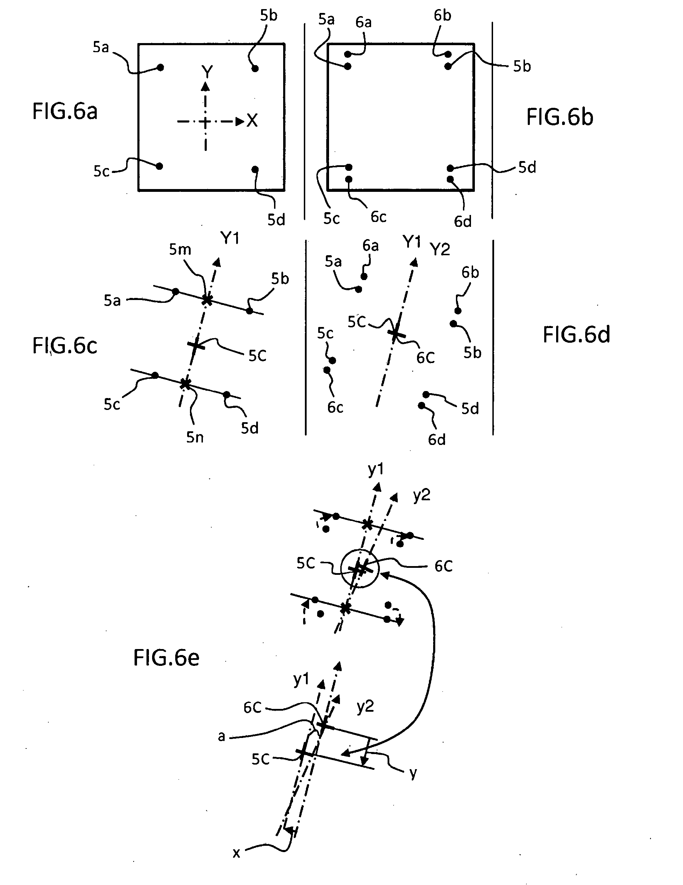

Les figures 6a à 6e illustrent un mode d'exécution de l'invention, qui repose sur le positionnement de quatre premières mires 5a à 5d lors de la première couche d'impression, puis quatre secondes mires 6a à 6d lors de la seconde couche d'impression, ces huit mires étant réparties de manière symétrique autour d'un référentiel X, Y de sorte de bénéficier du même centre ou barycentre 5C, 6C théorique. Cette géométrie permet de raisonner sur des droites Y1, Y2 qui passent respectivement par deux milieux 5m, 5n définis par les premières mires 5a, 5b et 5c, 5d, et de manière similaire par deux milieux définis par les secondes mires 6a, 6b, et 6c, 6d. Dans une situation d'alignement parfait, les deux droites Y1 et Y2 sont superposées. La figure 6e illustre la situation après usure des écrans. Le décalage entre les deux droites Y1, Y2 permet de définir le non alignement relatif entre les premières et secondes impressions. Ce décalage est défini par les trois valeurs x, y, a, (x, y) représentant le vecteur de déplacement relatif entre les barycentres 5C, 6C et a l'angle entre les droites Y1, Y2. Ces trois valeurs sont calculées par le dispositif d'inspection et de correction et servent de base à l'alignement des prochaines impressions.

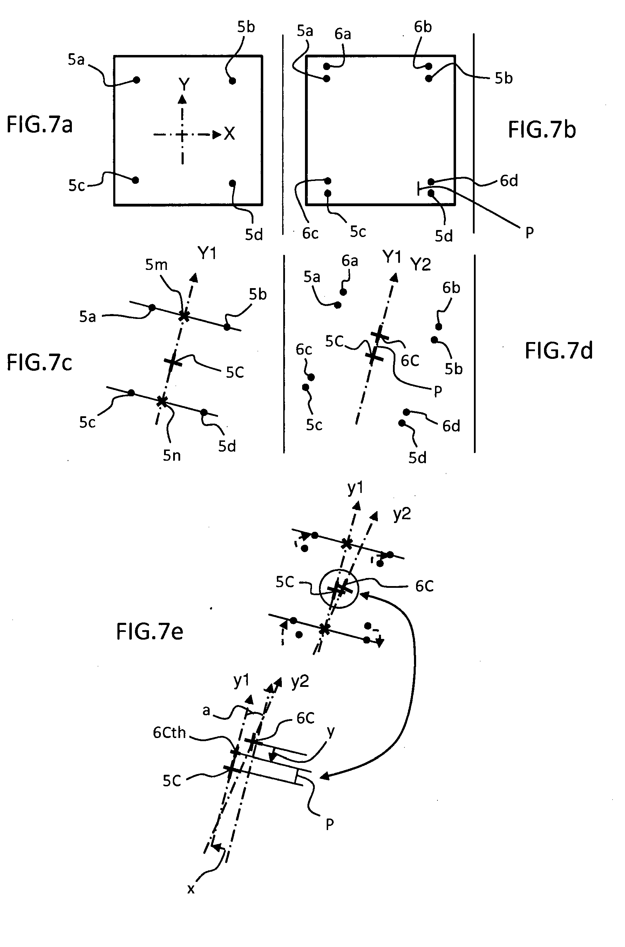

Les figures 7a à 7e illustrent une variante du mode d'exécution précédent de l'invention, dans laquelle les premières et secondes mires 5a à 5d, 6a à 6d sont toutes décalées de la même manière d'une distance P. Les centres respectifs ou barycentres 5C, 6C des premières et secondes mires sont donc de même décalés de la même distance P et les deux droites Y1, Y2 définies comme précédemment sont alignées. Les figures 7b et 7d représentent ces différentes mires et points. La figure 7e montre un décalage obtenu après usure, dans lequel le barycentre 6C des secondes mires est décalé par rapport à sa position théorique 6Cth qui serait obtenu avec un décalage P tel que représenté en figure 7d. Il est ainsi possible de mesurer un décalage théorique défini par les trois valeurs x, y, a comme dans l'exemple précédent.

En remarque, le décalage entre les premières et les secondes mires a été mesuré sur la base de la comparaison du décalage de leur barycentre respectif dans les exemples précédents. Toutefois, toute autre méthode équivalente pour mesurer tout ou partie du décalage entre les mires pourrait être mise en oeuvre.

L'invention porte aussi sur un dispositif pour réaliser une sérigraphie en au moins deux couches sur une plaque du type de celui destiné à une cellule photovoltaïque, qui comprend un dispositif d'inspection ou de visualisation de l'alignement mettant en oeuvre le procédé décrit précédemment. Ce dispositif d'inspection peut comprendre plusieurs caméras de haute précision, comme quatre caméras de résolution entre 1 ou 2 millions de pixels traitant chacune respectivement les motifs d'alignement 5a à 5d, et 6a à 6d. En variante, une seule caméra de plus forte résolution, telle que de l'ordre de 10 millions de pixels, pourrait observer tous les motifs d'alignement et atteindre un résultat équivalent. En remarque, cette solution peut être combinée à une inspection de l'intégrité de la plaque 1, à l'aide par exemple d'une caméra centrale à grand angle de vue. Ensuite, cette ou ces caméra(s) transmet(tent) les images observées à une unité de traitement, comprenant un calculateur qui comprend un logiciel mettant en oeuvre le procédé d'alignement du dispositif de sérigraphie décrit ci-dessus.

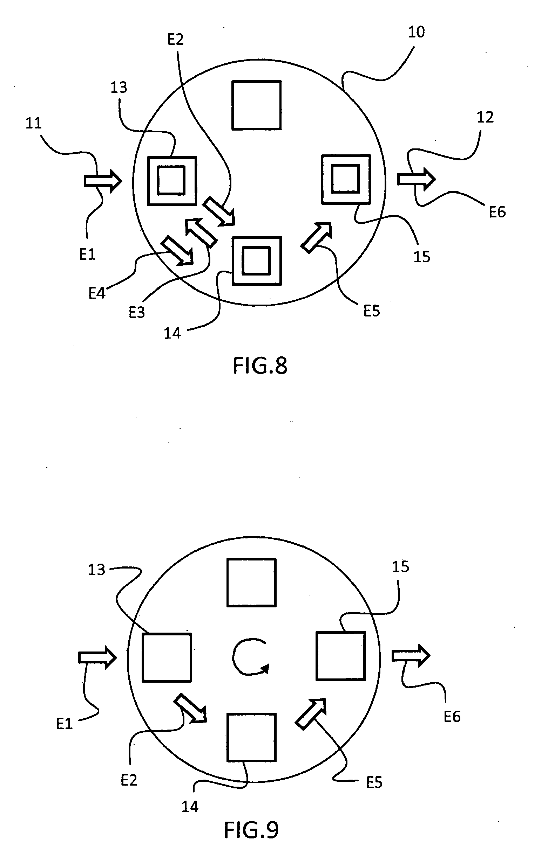

La figure 8 représente ainsi un poste de sérigraphie 10 qui se présente sous la forme d'une table rotative. Les plaques arrivent par une entrée 11 sur le poste de sérigraphie 10 et en ressortent par une sortie 12. Deux tables similaires distinctes sont utilisées pour réaliser respectivement la première impression et pour réaliser la seconde impression. En variante, la première couche pourrait être réalisée par une autre technique que la sérigraphie, comme cela a été mentionné précédemment, et le dispositif de la première couche diffèrerait alors de celui de la seconde couche sérigraphique.

Dans le cas de la seconde impression, représentée sur la figure 8, les plaques entrent donc sur la table d'impression 10 en vue de la réalisation de la seconde impression par l'entrée 11. Une première impression a donc déjà été réalisée sur une précédente table d'impression, non représentée. La première étape E1 lors de cette arrivée consiste à réaliser une première inspection dans l'unité d'inspection 13 afin de déterminer le décalage des premières mires, causé par le mauvais alignement entre la plaque et l'écran de la première table d'impression sérigraphique. Ensuite, dans une seconde étape E2, les plaques sont dirigées vers l'unité d'impression 14 où elles subissent la seconde impression, permettant de réaliser la seconde couche 3 d'encre conductrice. Dans une troisième étape E3, les plaques sont renvoyées sous la table d'inspection 13 pour effectuer une nouvelle inspection du décalage relatif entre les premières et secondes impressions, causé par le mauvais alignement de la plaque avec le second écran d'impression. Suite à cette dernière inspection, la plaque est alors conduite vers une unité de contrôle 15 dans une cinquième étape E5 après son passage de nouveau par la table d'impression lors d'une quatrième étape E4, durant laquelle aucune impression n'est réalisée. Enfin, lors d'une étape E6, la plaque est dirigée hors de la table sérigraphique par la sortie 12.

Selon une réalisation avantageuse de l'invention, le processus précédent d'alignement du second écran n'est pas réalisé pour chaque plaque circulant sur la table sérigraphique 10 mais selon une période prédéfinie. Par exemple, comme les décalages causés par les deux écrans sont très progressifs, la réalisation du parcours explicité ci-dessus peut n'être réalisée que toutes les 500 plaques, ce qui réduit le nombre des étapes E3, E4 réellement effectuées, qui impliquent un aller-retour d'une plaque et une baisse de productivité du procédé global de fabrication. Avantageusement, une l'inspection de la seconde impression peut être effectuée selon une période supérieure ou égale à toutes les 200 plaques. Ainsi, la mise en oeuvre du procédé de l'invention induit finalement un ralentissement négligeable de la production des cellules photovoltaïques et la capacité de la ligne de production est peu impactée par la mise en oeuvre de l'invention. Pour toutes les plaques intermédiaires, pour lesquelles la seconde inspection n'est pas mise en oeuvre, le parcours obtenu est simplifié, tel que représenté sur la figure 9, pour lequel les deux étapes E3, E4 ne sont pas mises en oeuvre, la sérigraphie de ces plaques étant réalisée en utilisant le dernier décalage calculé.

En variante, le dispositif précédent pourrait être modifié afin d'inclure une seconde unité d'inspection disposée après l'unité d'impression 14, pour éviter l'aller-retour des étapes E3, E4. Cette variante de mise en oeuvre équivalente du procédé de l'invention permettrait l'accélération de la ligne de production mais induirait un surcoût de l'installation par rapport au dispositif illustré sur les figures 8 et 9.

Ainsi, l'invention offre l'avantage de permettre l'utilisation du procédé d'impression par sérigraphie sur une plaque de cellule photovoltaïque par un procédé de double impression en garantissant la superposition avec grande précision des deux impressions, sur une grande durée qui peut aller au-delà de 10000 impressions.

Le mode d'exécution préféré de l'invention a été décrit avec une superposition de deux impressions par sérigraphie, utilisant quatre mires à chaque étape d'impression. Toutefois, la première couche peut être réalisée par toute autre technique, comme cela a été mentionné, et seulement deux mires peuvent suffire pour cette première couche, seule la seconde impression exigeant la réalisation d'au moins quatre mires pour obtenir la quantité d'information suffisante afin de déterminer l'erreur produite par la déformation particulière de l'écran sérigraphique dans toutes les directions, combinée avec sa superposition sur une première couche.

## Revendications

1. Procédé d'impression par sérigraphie d'une plaque (1), comprenant les étapes suivantes :
- réalisation d'au moins deux premières mires (5a - 5d) sur la surface (4) de la plaque (1) ;
- Impression d'au moins quatre secondes mires (6a - 6d), distinctes des au moins deux premières mires (5a - 5d), lors d'une impression par sérigraphie sur la surface (4) de la plaque (1) ;
- Mesure de l'écart réel obtenu sur la surface (4) de la plaque (1) entre les premières mires (5a - 5d) et les secondes mires (6a - 6d) ;
- Comparaison de cet écart réel avec l'écart théorique pour en déduire le décalage de l'écran (25) sérigraphique de l'impression.

2. Procédé d'impression par sérigraphie d'une plaque (1) selon la revendication 1, **caractérisé en ce qu'**il comprend une étape de modification de la position de l'écran (25) de sérigraphie de l'impression afin de réduire ou supprimer son décalage.

3. Procédé d'impression par sérigraphie d'une plaque (1) selon la revendication 1 ou 2, **caractérisé en ce que** la réalisation des premières mires se fait lors d'une impression par sérigraphie et **en ce qu'**il y a impression d'au moins quatre premières mires.

4. Procédé d'impression par sérigraphie d'une plaque (1) selon la revendication précédente, **caractérisé en ce que** l'impression des premières mires (5a - 5d) est réalisée lors de l'impression d'une première couche (2) d'encre sur la surface (4) de la plaque (1) et **en ce que** l'impression des secondes mires (6a - 6d) est réalisée lors de l'impression d'une seconde couche (3) d'encre, superposée à la première couche (2) sur la surface (4) de la plaque (1) lorsqu'il n'y a pas de décalage des écrans (25) sérigraphiques des deux impressions.

5. Procédé d'impression par sérigraphie d'une plaque (1) selon l'une des revendications précédentes, **caractérisé en ce qu'**il comprend une étape d'inspection des premières mires (5a - 5d) avant l'impression des secondes mires (6a-6d), qui comprend la mesure du décalage des premières mires (5a-5d) par rapport à leur position théorique et **en ce qu'**il comprend une modification de la position de l'écran (20) sérigraphique de la première impression pour supprimer ou réduire ce décalage.

6. Procédé d'impression par sérigraphie d'une plaque (1) selon l'une des revendications précédentes, **caractérisé en ce qu'**il comprend une étape de séchage de la au moins une première mire (5a-5d) avant l'impression de la au moins une seconde mire (6a-6d).

7. Procédé d'impression par sérigraphie d'une plaque (1) selon l'une des revendications précédentes, **caractérisé en ce que** les premières mires (5a-5d) et/ou les secondes mires (6a-6d) sont réparties en périphérie de la plaque (1).

8. Procédé d'impression par sérigraphie d'une plaque (1) selon la revendication précédente, **caractérisé en ce que** les mires sont réparties de manière symétrique autour d'un même centre (5C, 6C) de symétrie dans leur position théorique obtenue lors d'une impression sans décalage des écrans (20, 25) sérigraphiques.

9. Procédé d'impression par sérigraphie d'une plaque (1) selon l'une des revendications précédentes, **caractérisé en ce que** les mires sont réparties dans les quatre angles si la plaque est un parallélogramme.

10. Procédé d'impression par sérigraphie d'une plaque (1) selon l'une des revendications 1 à 7, **caractérisé en ce que** les premières mires (5a-5d) et les secondes mires (6a-6d) sont toutes décalées de la même manière d'une distance (P).

11. Procédé d'impression par sérigraphie d'une plaque (1) selon la revendication 3, **caractérisé en ce que** les premières mires (5a-5d) et les secondes mires (6a-6d) comprennent une partie du circuit sérigraphié.

12. Procédé d'impression par sérigraphie d'une plaque (1) selon l'une des revendications précédentes, **caractérisé en ce qu'**il comprend une étape (E1) d'entrée de la plaque sur une table d'impression (10), une étape (E2) de positionnement de la plaque dans une unité d'impression (14) où elle subit la seconde impression, et une étape (E3) de positionnement de la plaque dans une unité d'inspection (13) pour mesurer et en déduire le décalage de l'écran (25) sérigraphique de la seconde impression.

13. Procédé d'impression par sérigraphie d'une plaque (1) selon la revendication précédente, **caractérisé en ce que** la première étape (E1) d'entrée sur la table d'impression (10) positionne la plaque (1) dans l'unité d'inspection (13) pour mesurer la position des mires de la première impression, **en ce que** l'étape (E3) de positionnement de la plaque dans une unité d'inspection (13) consiste en un positionnement par un mouvement arrière de la plaque sous la même unité d'inspection que celle atteinte lors de l'entrée (E1) de la plaque (1) sur la table d'impression (10), et **en ce qu'**il comprend une étape de repositionnement de la plaque sous l'unité d'impression (14) sans réaliser son impression avant sa sortie (E6) de la table d'impression.

14. Procédé d'impression par sérigraphie de plusieurs plaques (1) selon la revendication 12 ou 13, **caractérisé en ce qu'**il ne réalise l'inspection (E3) de la seconde impression dans l'unité d'inspection (13) que périodiquement, pas pour toutes les plaques (1).

15. Procédé de fabrication d'une cellule photovoltaïque, **caractérisé en ce qu'**il comprend un procédé d'impression de tout ou partie des conducteurs de collecte de la cellule photovoltaïque selon l'une des revendications précédentes.

16. Dispositif d'impression sérigraphique comprenant au moins une unité d'impression sérigraphique et au moins une unité d'inspection, **caractérisé en ce que** l'unité d'impression sérigraphique met en oeuvre l'impression d'au moins quatre mires (6a-6d) et **en ce que** le dispositif met en oeuvre le procédé d'impression par sérigraphie selon l'une des revendications 1 à 14.

17. Dispositif d'impression sérigraphique selon la revendication précédente, **caractérisé en ce que** l'unité d'inspection comprend au moins une caméra à haute résolution et un calculateur.

18. Cellule photovoltaïque, **caractérisée en ce qu'**elle comprend au moins un conducteur comprenant au moins deux couches superposées (2, 3), et au moins deux premières mires (5a-5d) et au moins quatre secondes mires sérigraphiques (6a-6d) distinctes.

19. Cellule photovoltaïque selon la revendication précédente, **caractérisée en ce qu'**elle comprend au moins quatre premières mires (5a-5d) sérigraphiques.

## Patentansprüche

1. Verfahren zum Drucken durch Siebdruck einer Platte (1), das die folgenden Schritte umfasst:
- Verwirklichen von wenigstens zwei ersten Mustern (5a-5d) auf der Oberfläche (4) der Platte (1);
- Drucken von wenigstens vier zweiten Mustern (6a-6d), die von den wenigstens zwei ersten Mustern (5a-5d) verschieden sind, wenn auf der Oberfläche (4) der Platte (1) ein Drucken durch Siebdruck erfolgt;
- Messen des Ist-Abstands, der auf der Oberfläche (4) der Platte (1) zwischen den ersten Mustern (5a-5d) und den zweiten Mustern (6a-6d) erhalten wird;
- Vergleichen dieses Ist-Abstands mit dem theoretischen Abstand, um daraus den Versatz des Siebdruckschirms (25) des Druckens abzuleiten.

2. Verfahren zum Drucken durch Siebdruck einer Platte (1) nach Anspruch 1, **dadurch gekennzeichnet, dass** es einen Schritt des Modifizierens der Position des Siebdruckschirms (25) des Druckens umfasst, um ihren Versatz zu verringern oder zu unterdrücken.

3. Verfahren zum Drucken durch Siebdruck einer Platte (1) nach Anspruch 1 oder 2, **dadurch gekennzeichnet, dass** die Verwirklichung der ersten Muster während eines Druckens durch Siebdruck erfolgt und dass ein Druck von wenigstens vier ersten Mustern vorgesehen ist.

4. Verfahren zum Drucken durch Siebdruck einer Platte (1) nach dem vorhergehenden Anspruch, **dadurch gekennzeichnet, dass** das Drucken der ersten Muster (5a-5d) verwirklicht wird, wenn eine erste Tintenschicht (2) auf der Oberfläche (4) der Platte (1) gedruckt wird, und dass das Drucken der zweiten Muster (6a-6d) verwirklicht wird, wenn eine zweite Tintenschicht (3), die der ersten Schicht (2) überlagert ist, auf der Oberfläche (4) der Platte (1) gedruckt wird, wenn kein Versatz der Siebdruckschirme (25) der zwei Druckvorgänge vorhanden ist.

5. Verfahren zum Drucken durch Siebdruck einer Platte (1) nach einem der vorhergehenden Ansprüche, **dadurch gekennzeichnet, dass** es einen Schritt des Untersuchens der ersten Muster (5a-5d) vor dem Druck der zweiten Muster (6a-6d) umfasst, das das Messen des Versatzes der ersten Muster (5a-5d) in Bezug auf ihre theoretische Position umfasst, und dass es eine Modifikation der Position des Siebdruckschirms (20) des ersten Druckvorgangs umfasst, um diesen Versatz zu unterdrücken oder zu verringern.

6. Verfahren zum Drucken durch Siebdruck einer Platte (1) nach einem der vorhergehenden Ansprüche, **dadurch gekennzeichnet, dass** es einen Schritt des Trocknens des wenigstens einen ersten Musters (5a-5d) vor dem Drucken des wenigstens einen zweiten Musters (6a-6d) umfasst.

7. Verfahren zum Drucken durch Siebdruck einer Platte (1) nach einem der vorhergehenden Ansprüche, **dadurch gekennzeichnet, dass** die ersten Muster (5a-5d) und/oder die zweiten Muster (6a-6d) am Umfang der Platte (1) verteilt sind.

8. Verfahren zum Drucken durch Siebdruck einer Platte (1) nach dem vorhergehenden Anspruch, **dadurch gekennzeichnet, dass** die Muster symmetrisch um dasselbe Symmetriezentrum (5C, 6C) an ihrer theoretischen Position, die bei einem Drucken ohne Versatz der Siebdruckschirme (20, 25) erhalten wird, verteilt sind.

9. Verfahren zum Drucken durch Siebdruck einer Platte (1) nach einem der vorhergehenden Ansprüche, **dadurch gekennzeichnet, dass** die Muster in den vier Ecken verteilt sind, wenn die Platte ein Parallelogramm ist.

10. Verfahren zum Drucken durch Siebdruck einer Platte (1) nach einem der Ansprüche 1 bis 7, **dadurch gekennzeichnet, dass** die ersten Muster (5a-5d) und die zweiten Muster (6a-6d) alle auf gleiche Weise um eine Strecke (P) versetzt sind.

11. Verfahren zum Drucken durch Siebdruck einer Platte (1) nach Anspruch 3, **dadurch gekennzeichnet, dass** die ersten Muster (5a-5d) und die zweiten Muster (6a-6d) einen Siebdruck-Schaltungsabschnitt umfassen.

12. Verfahren zum Drucken durch Siebdruck einer Platte (1) nach einem der vorhergehenden Ansprüche, **dadurch gekennzeichnet, dass** es einen Schritt (E1) des Aufsetzens der Platte auf einen Drucktisch (10), einen Schritt (E2) des Positionierens der Platte in einer Druckeinheit (14), wo sie dem zweiten Druck unterworfen wird, und einen Schritt (E3) des Positionierens der Platte in einer Untersuchungseinheit (13), um den Versatz des Siebdruckschirms (25) des zweiten Druckvorgangs zu messen und daraus abzuleiten.

13. Verfahren zum Drucken durch Siebdruck einer Platte (1) nach dem vorhergehenden Anspruch, **dadurch gekennzeichnet, dass** der erste Schritt (E1) des Aufsetzens auf den Drucktisch (10) die Platte (1) in einer Untersuchungseinheit (13) positioniert, um die Position der Muster des ersten Druckvorgangs zu messen, dass der Schritt (E3) des Positionierens der Platte in einer Untersuchungseinheit (13) aus einem Positionieren durch eine Rückwärtsbewegung der Platte unter derselben Untersuchungseinheit wie jene, die beim Aufsetzen (E1) der Platte (1) auf den Drucktisch (10) erreicht wird, besteht und dass es einen Schritt des erneuten Positionierens der Platte unter der Druckeinheit (14), ohne ihren Druck zu verwirklichen, bevor sie den Drucktisch verlässt (E6), umfasst.

14. Verfahren zum Drucken durch Siebdruck mehrerer Platten (1) nach Anspruch 12 oder 13, **dadurch gekennzeichnet, dass** die Untersuchung (E3) des zweiten Druckvorgangs in der Untersuchungseinheit (13) nur periodisch, nicht für alle Platten (1), verwirklicht wird.

15. Verfahren für die Fertigung einer Photovoltaikzelle, **dadurch gekennzeichnet, dass** es ein Verfahren zum Drucken nach einem der vorhergehenden Ansprüche aller Sammelleiter oder eines Teils hiervon der Photovoltaikzelle umfasst.

16. Siebdruck-Druckvorrichtung, die wenigstens eine Siebdruck-Druckeinheit und wenigstens eine Untersuchungseinheit umfasst, **dadurch gekennzeichnet, dass** die Siebdruck-Druckeinheit das Drucken von wenigstens vier Mustern (6a-6d) ausführt und dass die Vorrichtung das Verfahren zum Drucken durch Siebdruck nach einem der Ansprüche 1 bis 14 ausführt.

17. Siebdruck-Druckvorrichtung nach dem vorhergehenden Anspruch, **dadurch gekennzeichnet, dass** die Untersuchungseinheit wenigstens eine hochauflösende Kamera und einen Computer umfasst.

18. Photovoltaikzelle, **dadurch gekennzeichnet, dass** sie wenigstens einen Leiter, der wenigstens zwei übereinander liegende Schichten (2, 3) und wenigstens zwei erste Muster (5a-5d) sowie wenigstens vier zweite Siebdruckmuster (6a-6d), die davon verschieden sind, enthält, umfasst.

19. Photovoltaikzelle nach dem vorhergehenden Anspruch, **dadurch gekennzeichnet, dass** sie wenigstens vier erste Siebdruckmuster (5a-5d) umfasst.

## Claims

1. Method for printing on a wafer (1) by screen-printing, comprising the following steps:
- producing at least two first test-patterns (5a - 5d) on the surface (4) of the wafer (1);
- printing at least four second test-patterns (6a - 6d), distinct from the at least two first test-patterns (5a - 5d), during printing on the surface (4) of the wafer (1) by screen-printing;
- measuring the actual distance obtained on the surface (4) of the wafer (1) between the first test-patterns (5a - 5d) and the second test-patterns (6a - 6d);
- comparing this actual distance with a theoretical distance in order to deduce therefrom the offset of the screen-printing screen (25) of the printing.

2. Method for printing on a wafer (1) by screen-printing according to Claim 1, **characterized in that** it comprises a step of modifying the position of the screen-printing screen (25) of the printing in order to reduce or eliminate its offset.

3. Method for printing on a wafer (1) by screen-printing according to Claim 1 or 2, **characterized in that** the first test-patterns are produced during printing by screen-printing, and **in that** at least four first test-patterns are printed.

4. Method for printing on a wafer (1) by screen-printing according to the preceding claim, **characterized in that** the first test-patterns (5a - 5d) are printed when printing a first layer (2) of ink on the surface (4) of the wafer (1), and **in that** the second test-patterns (6a - 6d) are printed when printing a second layer (3) of ink, which is superimposed on the first layer (2) on the surface (4) of the wafer (1) when there is no offset of the screen-printing screens (25) of the two printings.

5. Method for printing on a wafer (1) by screen-printing according to one of the preceding claims, **characterized in that** it comprises a step of inspecting the first test-patterns (5a - 5d) before printing the second test-patterns (6a-6d), which comprises measuring the offset of the first test-patterns (5a-5d) with respect to their theoretical position, and **in that** it comprises a modification of the position of the screen-printing screen (20) of the first printing in order to eliminate or reduce this offset.

6. Method for printing on a wafer (1) by screen-printing according to one of the preceding claims, **characterized in that** it comprises a step of drying the at least one first test-pattern (5a-5d) before printing the at least one second test-pattern (6a-6d).

7. Method for printing on a wafer (1) by screen-printing according to one of the preceding claims, **characterized in that** the first test-patterns (5a-5d) and/or the second test-patterns (6a-6d) are distributed at the periphery of the wafer (1).

8. Method for printing on a wafer (1) by screen-printing according to claim 7, **characterized in that** the test-patterns are distributed symmetrically around the same centre (5C, 6C) of symmetry in their theoretical position, as obtained when printing without an offset of the screen-printing screens (20, 25).

9. Method for printing on a wafer (1) by screen-printing according to one of the preceding claims, **characterized in that** the test-patterns are distributed in the four angles if the wafer is a parallelogram.

10. Method for printing on a wafer (1) by screen-printing according to one of Claims 1 to 7, **characterized in that** the first test-patterns (5a-5d) and the second test-patterns (6a-6d) are all offset in the same way by a distance (P).

11. Method for printing on a wafer (1) by screen-printing according to Claim 3, **characterized in that** the first test-patterns (5a-5d) and the second test-patterns (6a-6d) comprise a part of the screen-printed circuit.

12. Method for printing on a wafer (1) by screen-printing according to one of the preceding claims, **characterized in that** it comprises a step (E1) of entering the wafer onto a printing table (10), a step (E2) of positioning the wafer in a printing unit (14) in which it undergoes the second printing, and a step (E3) of positioning the wafer in an inspection unit (13) in order to measure and deduce therefrom the offset of the screen-printing screen (25) of the second printing.

13. Method for printing on a wafer (1) by screen-printing according to claim 12, **characterized in that** the first step (E1) of entry on the printing table (10) positions the wafer (1) in the inspection unit (13) in order to measure the position of the test-patterns of the first printing, and **in that** the step (E3) of positioning the wafer in an inspection unit (13) consists in positioning the wafer by backwards movement under the same inspection unit as that reached during entry (E1) of the wafer (1) on the printing table (10), and **in that** it comprises a step of repositioning the wafer under the printing unit (14) without printing it before its exit (E6) from the printing table.

14. Method for printing on a wafer (1) by screen-printing according to Claim 12 or 13, **characterized in that** the inspection (E3) of the second printing in the inspection unit (13) is only carried out periodically, not for all the wafers (1).

15. Method for fabricating a photovoltaic cell, **characterized in that** it comprises a method of printing some or all of the collection conductors of the photovoltaic cell according to one of the preceding claims.

16. Screen-printing device comprising at least one screen-printing unit and at least one inspection unit, **characterized in that** the screen-printing unit carries out the printing of at least four test-patterns (6a-6d), and **in that** the device carries out the screen-printing method according to one of Claims 1 to 14.

17. Screen-printing device according to the preceding claim, **characterized in that** the inspection unit comprises at least one high-resolution camera and a computer.

18. Photovoltaic cell, **characterized in that** it comprises at least one conductor comprising at least two superimposed layers (2, 3), and at least two first screen-printing test-patterns (5a-5d) and at least four second screen-printing test-patterns (6a-6d) which are distinct.

19. Photovoltaic cell according to the preceding claim, **characterized in that** it comprises at least four first screen-printing test-patterns (5a-5d).
